# EUROPEAN PATENT SPECIFICATION

(11) **EP 3 179 260 B1**
(45) Date of publication and mention of the grant of the patent: **26.09.2018**
(21) Application number: 15199266.6
(22) Date of filing: 10.12.2015
(51) Int. Cl.: G01R 31/30, G01R 31/317, H02M 3/00, G01R 31/28, G05F 1/10, H03K 5/19, H03K 5/00

(54) **APPARATUS AND METHOD FOR MONITORING PERFORMANCE OF INTEGRATED CIRCUIT**
VORRICHTUNG UND VERFAHREN ZUR ÜBERWACHUNG DER LEISTUNG EINER INTEGRIERTEN SCHALTUNG
APPAREIL ET PROCÉDÉ POUR SURVEILLER LA PERFORMANCE D'UN CIRCUIT INTÉGRÉ

(43) Date of publication of application: 14.06.2017
(73) Proprietor: Stichting IMEC Nederland, 5656 AE Eindhoven (NL)
(72) Inventor: STUIJT, Jan, 3001 Leuven (BE)
(74) Representative: AWA Sweden AB

(56) References cited:
- US-A1- 2003 093 160
- US-A1- 2005 007 154
- US-A1- 2012 262 213
- US-B1- 8 004 329

## Description

### Technical Field

The present invention relates to an apparatus and a method for monitoring performance of an integrated circuit.

### Background

Integrated circuits are driven by a supply voltage and a clock frequency. Power consumption of the integrated circuit may be significantly lowered by decreasing the supply voltage and/or the clock frequency.

However, in order for the integrated circuit to function properly, critical operations need to be able to be performed sufficiently fast. Lowering the supply voltage and/or the clock frequency reduces speed of the integrated circuit. Also, speed of the integrated circuit may depend on other factors, such as ambient temperature and quality of silicon integrated circuit fabrication.

In order to provide efficient power management, the supply voltage and/or the clock frequency may be adjusted to the prevailing speed of the integrated circuit. For instance, digital voltage/frequency scaling (DVFS) and adaptive voltage scaling (AVS) are known techniques for power management.

In order to enable adjusting of the supply voltage and/or the clock frequency, the prevailing speed needs to be measured. This may typically be provided by an on-chip performance monitor. The performance monitor may comprise a delay line, which replicates a critical path of the integrated circuit. Since the delay line is arranged on-chip, it will adapt to prevailing conditions and provide a relevant measurement of the speed of the integrated circuit.

The delay line may consist of a chain of delay units. A pulse signal may be launched at start of a clock cycle and then the delay line may be tapped at a plurality of positions. A thermometer output code is formed at the tapped positions of the delay line. A transition from 1 to 0 or 0 to 1 then provides a direct measure of the silicon speed in terms of the number N of tap delays Δ*t* per clock period *T*(*N* = *T*/Δ*t,* when *N* is larger the silicon is faster). Thus, the supply voltage and/or the clock frequency may be adjusted in relation to the measured speed.

However, it would be desired that performance monitors use a smaller silicon area and consume less power.

In US 8,004,329, there is disclosed an apparatus including a delay line having multiple delay cells coupled in series. The delay line is configurd to receive an input signal and to propagate the input signal through the delay cells. The apparatus also includes multiple sampling circuits configured to sample the input signal at different taps in the delay line and output sampled values. The delay line has a finer resolution closer to a target tap and a coarser resolution farther away from the target tap. Thus, the number of taps used may be improved by the finer resolution closer to the target tap. However, the apparatus still uses a large number of taps and related sampling flipflops, each adding to the silicon area and power consumption.

### Summary of the Invention

It is an object of the invention to enable monitoring performance of an integrated circuit using a small silicon area and/or low power consumption.

These and other objects of the invention are at least partly met by the invention as defined in the independent claims. Preferred embodiments are set out in the dependent claims.

According to a first aspect of the invention, there is provided an apparatus for monitoring performance of an integrated circuit, said apparatus comprising: a delay line, which is arranged to receive a pulse signal, wherein the delay line has a controllable, variable length and is arranged to propagate the pulse signal through a set length; a comparator, which is arranged to receive the propagated pulse signal from the delay line and a clock signal, said comparator being arranged to determine whether the received signal is received early or late; and a feedback loop, which receives input from the comparator for dynamically increasing or decreasing the set length of the delay line in dependence of the determination by the comparator; wherein said apparatus is arranged to determine a speed of the integrated circuit based on a determination by the comparator that the signal from the delay line closely matches the clock signal.

According to a second aspect of the invention, there is provided a method for monitoring performance of an integrated circuit, said method comprising: sending a pulse signal along a delay line having a controllable, variable length and being arranged to propagate the pulse signal through a set length; comparing a received pulse signal from the delay line to a clock signal to determine whether the received signal is received early or late; in dependence of the determination whether the received signal is received early or late, dynamically changing the set length of the delay line; sending another pulse signal along the delay line using the changed set length; and repeating the comparing of the received pulse signal from the delay line to a clock signal, dynamically changing the set length of the delay line and sending another pulse signal until the comparing determines that the received pulse signal closely matches the clock signal; and determining a speed of the integrated circuit based on the determination that the received pulse signal closely matches the clock signal.

According to the invention, use is made of a delay line having a controllable, variable length. The length of the delay line is dynamically changed during determination of speed of the integrated circuit. Instead of directly providing a determined speed of the integrated circuit, a feedback loop is provided for changing the length of the delay line until the comparator determines that the received pulse signal closely matches the clock signal.

This implies that a very simple comparator may be used, which may merely compare a pulse signal from the delay line to the clock signal. Further, the apparatus for monitoring performance need not comprise a plurality of tap positions. Rather, a single tap position corresponding to the current length of the delay line is used. Thus, the apparatus may provide monitoring of performance using a very small silicon area.

According to the invention, feedback is needed to dynamically change the delay line. This implies that a plurality of pulse signals is sent along the delay line in order to determine the speed of the integrated circuit. Hence, the determination of speed according to the invention may be slower than methods using a plurality of tap positions.

The comparator may be arranged to determine whether the received signal is early or late. Upon changing the length of the delay line, the comparator may in a next iteration determine that a relation between the received signal and the clock signal changes state, i.e. that the received signal is now instead late or early. A determination that two sequential pulse signals arrive either early and late or late and early may be used for determining that the speed of the integrated circuit corresponds to a delay line having an approximate length used for the two sequential pulse signals. Hence, the comparator may not necessarily identify that the received signal exactly matches the clock signal.

Rather, in the context of this application, the comparator may determine that the received signal "closely matches" the clock signal, i.e. that the arrival of the received signal is close to the clock signal. For instance, when a close match is identified, two sequential pulse signals may cause an increase and a decrease of the length of the delay line, respectively. Thus, a decrease of the delay line length may imply that a pulse signal received late is instead received early or an increase of the delay line length may imply that a pulse signal received early is instead received late. The increase or decrease of the delay line length between sequential pulse signals may be one or a few units of delay elements in the delay line.

According to an embodiment, the comparator comprises a single bit indicator, which is arranged to switch state on arrival of the propagated pulse signal, said comparator comparing the state of the single bit indicator to the clock signal. Thus, the comparator may be a very simple component, such as a single flipflop. This implies that the apparatus uses a very small silicon area.

According to an embodiment, the feedback loop further comprises a length indicator, which is arranged to set a length of the delay line. Thus, the length of the delay line may be dynamically controlled by the length indicator.

According to an embodiment, the length indicator is arranged to set a return position of the pulse signal in the delay line. Thus, the pulse signal may propagate through the delay line to the return position, where the signal may turn and propagate back through a return path of the delay line. This also implies that a sequential pulse signal may be sent before the new length has been set, as long as the return position is set before the sequential pulse signal arrives at the return position. Also, the pulse signal may always be input and output through a common element in the delay line, which facilitates making connections to and from the delay line.

According to an embodiment, the length indicator comprises an encoder, which is arranged to output a binary representation of a length of the delay line. In one embodiment, the encoder may thus point to the return position of the delay line.

Similarly, according to an embodiment of the method, the delay line comprises a number of unit delay elements, and a length of the delay line is controlled by indicating the number of unit delay elements through which the pulse signal is to be propagated.

According to a further embodiment, the changing of the set length of the delay line changes the length of the delay line by increasing or decreasing by one the number of unit delay elements of the delay line through which the pulse signal is to be propagated. Thus, a one-step increment or decrement of the delay line length may be performed until the received signal closely matches the clock signal.

According to an embodiment of the apparatus, the feedback loop further comprises a counter for providing input to the encoder for increasing or decreasing the length of the delay line. The counter may thus simply provide an instruction to increase or decrease and the encoder may then adjust the length of the delay line by a default number of unit delay elements.

According to an embodiment, the length indicator comprises a shift register, which comprises a set of binary circuits, wherein each binary circuit corresponds to a length of the delay line. One of the binary circuits in the shift register may thus code the length of the delay line. A length of the delay line may be simply changed by shifting the information in the shift register in the correct direction for increasing or decreasing the length of the delay line.

According to an embodiment, the delay line, the comparator and the feedback loop together form a performance monitor circuit, and wherein the apparatus comprises a first and a second performance monitor circuit and wherein a threshold voltage of the delay line of the first performance monitor circuit is different from a threshold voltage of the delay line of the second performance monitor circuit.

A threshold voltage of a transistor determines leakage properties of the transistor. A greater threshold voltage implies a lower leakage power. However, the speed of a circuit is also slower for transistors having greater threshold voltage. In an integrated circuit, there may be a great number of logic paths, and these may include transistors having different threshold voltages. By means of a first and a second performance monitor circuit, it is possible to determine speeds for paths having different threshold voltages.

According to an embodiment, the delay line may comprise a static part and a dynamically configurable part. This implies that the delay line may comprise a part of a static length, through which the pulse signal is always propagated and a dynamic part having a varying length. Thus, the length of the delay line may be varied between a minimum length corresponding to the length of the static part and a maximum length corresponding to the length of the static part combined with a maximum length of the dynamically configurable part. This could be especially useful if it is known that the length of the delay line for providing a pulse signal closely matching the clock signal should always vary within a set interval.

According to an embodiment, the delay line comprises a chain of multiplexers, wherein a length of the chain through which the pulse signal is propagated is controllable. This may be an appropriate implementation of the delay line. However, it should be realized that other unit delay elements may be used, such as AND and OR gates.

According to a third aspect of the invention, there is provided a device for adaptive voltage scaling for an integrated circuit, said device comprising an apparatus according to the first aspect, wherein said determined speed of the integrated circuit is input to a voltage controller for controlling a supply voltage of the integrated circuit. Thus, the apparatus for monitoring performance of an integrated circuit may be used for adaptively controlling the supply voltage. The loop for determining the speed of the integrated circuit may be quite fast, as the length of the delay line may be adjusted every clock period for settling to a length such that the signal from the delay line closely matches the clock signa. This loop for determining the speed may thus be so fast that a speed of a control loop for controlling the supply voltage need not be substantially affected.

Similarly, according to an embodiment of the method, the method further comprises comparing the determined speed of the integrated circuit to a threshold speed and controlling a supply voltage of the integrated circuit in dependence of the comparison.

### Brief Description of Drawings

The above, as well as additional objects, features and advantages of the present inventive concept, will be better understood through the following illustrative and non-limiting detailed description of preferred embodiments of the present invention, with reference to the appended drawings. In the drawings like reference numerals will be used for like elements unless stated otherwise.
Fig. 1 is a schematic view of an apparatus for monitoring performance of an integrated circuit according to a first embodiment of the invention.
Fig. 2 is a schematic view of a delay line of the apparatus in Fig. 1.
Fig. 3 is a schematic view of an apparatus for monitoring performance of an integrated circuit according to a second embodiment of the invention.
Fig. 4 is a schematic view illustrating use of the apparatus of the first embodiment in an adaptive voltage scaling system.
Fig. 5 is a flow chart illustrating a method according to an embodiment of the invention.

### Detailed Description

Detailed embodiments of the present invention will now be described with reference to the drawings.

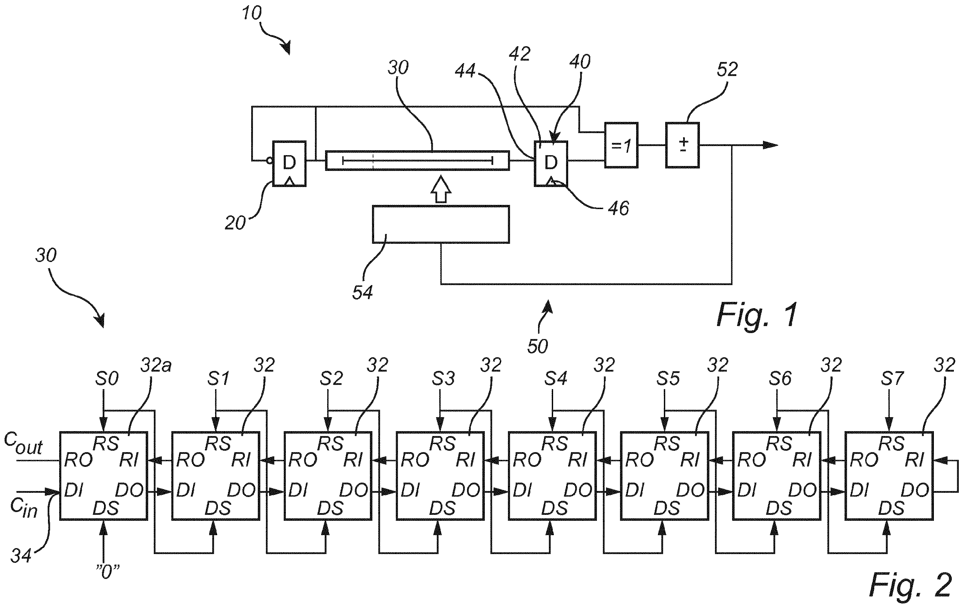

Reference is made to Fig. 1, in which an apparatus 10 for monitoring performance of an integrated circuit is schematically shown. The apparatus 10 may be arranged to determine speed of an integrated circuit. The apparatus 10 may be arranged on chip so as to be able to measure the speed of the integrated circuit for prevailing conditions. Also, a chip may be provided with a plurality of apparatuses 10 for monitoring performance, in order to be able to account for variations between different parts of the chip.

The apparatus 10 generally comprises a pulse signal generator 20 and a delay line 30, through which a pulse signal from the pulse signal generator 20 is sent. The apparatus 10 further comprises a comparator 40, which determines if the pulse signal that has propagated through the delay line 30 arrives early or late in relation to a clock signal. The comparator 40 is connected to a feedback loop 50 for controlling a length of the delay line 30 such that the length of the delay line 30 may be adjusted until arrival of the pulse signal closely matches the clock signal. Then, a measure of the speed of the integrated circuit may be output as a value related to the length of the delay line 30 that provided the pulse signal closely matching the clock signal.

A first embodiment of the apparatus 10 is shown in Fig. 1 and will now be described in further detail.

The pulse signal generator 20 may be arranged to generate a sequence of pulse signals. The pulse signal generator 20 may have an input 22 for receiving a clock signal, which may trigger the generation of a pulse signal. Thus, a pulse signal may be generated each clock cycle.

The pulse signal generator 20 may according to an embodiment be a delay flipflop, which may provide a pulse signal triggered by the clock signal.

The pulse signal generated by the pulse signal generator 20 may be sent to a delay line 30. The delay line 30 may have a controllable, variable length and the length of the delay line 30 may be controlled by the feedback loop 50.

The delay line 30 may be a chain of unit delay elements 32, such that the pulse signal is sequentially propagated through the chain of unit delay elelments 32. The unit delay elements 32 may be homogenous, such that each of the unit delay elements 32 causes an equal delay when the pulse signal is propagated through the chain.

The unit delay elements 32 may according to an embodiment be a two-input inverting multiplexer. The multiplexer has a stack of two n-type metal-oxide-semiconductor (NMOS) transistors and two p-type metal-oxide-semiconductor (PMOS) transistors, which makes a voltage-to-delay characteristic of the multiplexer representative of an average logic cell in the integrated circuit. Also, delay increments caused by the unit delay elements 32 are very similar, because internal wiring capacitances within the multiplexer are very predictable and constant.

However, as realized by a person skilled in the art, the unit delay elements 32 may be implemented in a lot of different ways. For instance, the unit dely elements 32 may include AND and/or OR gates.

As shown in Fig. 2, the delay line 30 may comprise a chain of unit delay elements 32, wherein a forward path and a return path are provided through the chain. Each unit delay element 32 comprises an input for receiving control signal S[0:7] controlling how a pulse signal is to be propagated through the delay line 30. A pulse signal, *Cᵢₙ*, enters the delay line through an input 34 of a first unit delay element 32a in the chain. If the control signal input on *DS* of the unit delay element 32, is "0" (or alternatively "1" depending on configuration), the pulse signal will be propagated through the unit delay element 32, from *DI* to DO, to an adjacent unit delay element 32 in the chain. However, if the control signal is "1", the pulse signal will instead be diverted to RO in the unit delay element 32 and returned back through the delay line 30 from *RI* to RO in the respective unit delay elements 32 based on the control signal input on RS of the respective unit delay element being "0". The pulse signal will thus be returned back to the first unit delay element 32a, where it is output, *Cₒᵤₜ.*

The control signals S[0:7] may thus control how many unit delay elements 32 that the pulse signal will be propagated through before reaching the output. As will be further discussed below, a length of the delay line 30 may thus be controlled by the control signals S[0:7].

It should be realized that in an alternative, the delay line 30 may be a chain of unit delay elements 32, wherein a start position or end position may be controlled for controlling the length of the delay line 30.

Referring again to Fig. 1, the pulse signal that is propagated through the delay line 30 may then be received by the comparator 40. The comparator 40 compares the propagated pulse signal to a clock signal in order to determine whether the pulse signal is arrived late or early in relation to the clock signal.

The comparator 40 may comprise a simple sampler 42 which compares two received signals in order to determine which arrived first. Thus, the sampler 42 may have a first input 44, which receives a pulse signal from the delay line 30. The signal on the input 44 may thus be a single "0" or "1 ", depending on whether the pulse signal has arrived or not. The sampler 42 may further have a second input 44, which receives the clock signal.

The sampler 42 may thus be implemented as a single bit indicator 42, which is arranged to switch state on arrival of the propagated pulse signal. The single bit indicator 42 then compares the state to the clock signal for providing an output in dependence whether the propagated pulse signal arrived before or after the clock signal. In one embodiment, the single bit indicator 40 may comprise a single flipflop, which receives the propagated pulse signal from the delay line 30 and the clock signal.

The comparator 40 may provide its output to a feedback loop 50, which may control a set length of the delay line 30. Thus, the feedback loop 50 is configured to adjust the length of the delay line 30 so that the propagated pulse signal should correspond to the clock signal and a speed of the integrated circuit may be determined based on which length of the delay line 30 gives a pulse signal closely matching the clock signal.

The feedback loop 50 may comprise a counter 52, which may determine how the length of the delay line 30 is to be adjusted based on the determination by the comparator 40. If the comparator 40 finds that the pulse signal has arrived late, the length of the delay line 30 should be decreased, whereas if the comparator 40 finds that the pulse signal has arrived early, the length of the delay line 30 should be increased. The counter 52 may hold a representation of the length of the delay line 30 and may increase or decrease the length according to the input from the comparator 40. The counter 52 may then output the representation of the length of the delay line 30. According to an alternative, the counter 52 may output a signal indicating that the length of the delay line 30 is to be increased or decreased.

The feedback loop 50 may further comprise a length indicator 54, which receives input from the counter 52. The length indicator 54 may provide a signal for setting the length of the delay line 30.

As shown in Fig. 1, the length indicator 54 may comprise an encoder, which may represent the set length of the delay line 30 as a binary number. Thus, the length of the delay line 30 may be encoded by a few bits, and the encoder may thus be implemented as a corresponding number of components, e.g. flipflops. Based on the length represented by the encoder, a signal may be provided from the encoder to the delay line 30 for controlling the length of the delay line 30. For instance, a signal may be provided for setting the return position for the delay line 30 as shown in Fig. 2, and hence setting the number of unit delay elements 32 that the pulse signal will be propagated through.

The length of the delay line 30 may thus be dynamically controlled and the length may be adjusted a plurality of times until the pulse signal matches the clock signal.

As mentioned above, the pulse signal generator 20 may generate a sequence of pulse signals. The length of the delay line 30 may be adjusted between each pulse signal in the sequence until the pulse signal closely matches the clock signal.

When the length of the delay line provides a pulse signal closely matching the clock signal, the feedback loop 50 may be arranged to alternately increase and decrease the length of the delay line 30 as the corresponding change of the length of the delay line 30 may alternately cause the propagated pulse signal to arrive early and late.

The comparator 40 may be arranged to identify when the length of the delay line 30 is closely matching the clock signal. According to an embodiment, the comparator 40 may include a simple checking component, which checks whether a determination that the received signal is received early or late differs from a previous determination. If two subsequent signals differ in relation to the clock signal in that one signal is received early and the other signal is received late, the comparator 40 may identify the received signal as closely matching the clock signal.

According to an embodiment, a simple digital filter may be used, which subtracts an output value *Nᵢ* of the length of the delay line 30 from a previous output value *N*_{*i*-*1*}. The difference *Dᵢ* = *Nᵢ* - *Nᵢ₋₁* may be either +1 or -1, if the length of the delay line 30 is always changed by a single unit delay element 32. The digital filter may then compare the difference *Dᵢ* to the previous difference *Dᵢ₋₁*, and when the differences are unequal, the received signal may be determined to closely match the clock period.

A length of the delay line 30 for providing the pulse signal closely matching the clock signal may be output from the apparatus 10 as a measure of the speed of the integrated circuit. Alternatively, another measure of the speed of the integrated circuit dependent on the length of the delay line 30 may be output, such as number *N* of tap delays Δ*t* (corresponding to the length of the delay line 30) per clock period *T*(*N* = *T*/Δ*t*).

According to an embodiment, the counter 52 may be arranged to change the length of the delay line 30 by a single unit delay element 32 at a time. However, it should be realized that other manners of changing the length of the delay line 30 may be contemplated. For instance, an amount of change of the length of the delay line 30 may initially be large (corresponding to several unit delay elements 32) and may be decreased between iterations as the feedback loop 50 provides a length of the delay line 30 providing a pulse signal better matching the clock signal.

A feedback loop 50 having an encoder 54 may dynamically change the length of the delay line 30 using a few components, such that a small silicon area is used while providing a good resolution in determining the speed of the integrated circuit. For instance, in comparison to an apparatus having 128 tap positions for providing measurements of the speed of the integrated circuit, 8 components, e.g. flipflops, are needed in order to encode 128 different lengths of the delay line 30. Thus, the silicon area needed by the apparatus 10 according to the invention is dramatically reduced in relation to an apparatus having a plurality of tap positions.

The small size of the apparatus 10 may also facilitate placing of the apparatus 10 on-chip, as constraints on where the apparatus 10 may fit are relatively insubstantial. Also, the small size of the apparatus 10 may allow a plurality of apparatuses 10 to be distributed over a chip e.g. for measuring variations between different parts of the chip.

Further, since only a few components are needed, the power dissipation of the apparatus 10 is also low. This may be particularly suitable as the apparatus 10 may often be used in an adaptive voltage scaling system, having a main purpose to reduce power dissipation of the integrated circuit.

The unit delay elements 32 of the delay line 30 may have a homogenous threshold voltage. The speed of the unit delay elements 32 may differ depending on the threshold voltage. By having a homogenous threshold voltage each of the unit delay elements 32 of the delay line 30 may have a common speed.

Further, apparatuses 10 for monitoring performance of an integrated circuit may be adapted to measure performance of logic paths comprising components with different threshold voltages.

Thus, the delay line 30 of a first apparatus 10 may comprise unit delay elements 32 having a first threshold voltage. The first apparatus 10 may thus be adapted to measure performance of logic paths comprising components with the first threshold voltage. The delay line 30 of a second apparatus 10 may comprise unit delay elements 32 having a second threshold voltage. The second apparatus 10 may thus be adapted to measure performance of logic paths comprising components with the second threshold voltage. The first and the second apparatus 10 may be provided on the same chip for providing information on the speed or performance of different logic paths on the chip comprising components with different threshold voltages. It should be realized that further apparatuses 10 may be used, wherein the delay lines 30 comprise unit delay elements 32 having other threshold voltages, different from the first and second threshold voltages.

Also or alternatively, the delay line 30 of the apparatus 10 may comprise a static part and a dynamically controllable part. Thus, the pulse signal from the pulse signal generator 20 may first be propagated through the static part having a fixed length before the pulse signal propagates through the dynamically controllable part, which may be implemented according to any of the embodiments disclosed above.

The speed of the integrated circuit may be known to vary within a predetermined interval. Then, the length of the delay line 30 may be known to always have a minimum length. Thus, instead of providing a delay line 30 that may have a varying length below the known minimum length, the delay line 30 may be provided with a static part corresponding to the minimum length.

For instance, if the integrated circuit has a fixed clock period and the supply voltage may be varied within a set interval, the delay line 30 may have a minimum length corresponding to the maximum supply voltage. Thus, the static part may have a number of unit delay elements 32 corresponding to the minimum length of the delay line 30. The encoder 54 may thus code a length within the set interval corresponding to different lengths of the dynamically controllable part of the delay line 30. Thus, the apparatus 10 may output a speed corresponding to a value provided by the encoder 54 which reflects a length of the static part combined with the dynamically controllable part. Such an embodiment may provide a somewhat simpler logic of the apparatus 10 as the static part of the delay line 30 does not need any dynamic control.

According to another embodiment, the static part of the delay line 30 of a first apparatus 10 may comprise unit delay elements 32 having a first threshold voltage, and the dynamically controllable part of the delay line 30 may comprise unit delay elements 32 having a second threshold voltage. This may be combined with a second apparatus 10, wherein the static part of the delay line 30 comprises unit delay elements 32 having the second threshold voltage, and the dynamically controllable part of the delay line 30 may comprise unit delay elements 32 having the first threshold voltage. Such first and second apparatuses 10 may be used for determining a speed of the integrated circuit, where a logic path in the integrated circuit contains cells of two different threshold voltages. For a low supply voltage, cells having a high threshold voltage may dominate a total delay caused by the logic path, whereas for a high supply voltage, cells having a low threshold voltage may dominate the total delay. In order to determine the speed of the integrated circuit, it may thus be beneficial to use apparatuses 10 comprising a mix of unit delay elements 32 having a low and a high threshold voltage.

If a minimum ratio of cells having a low threshold voltage in any logic path of the integrated circuit is *R_{low},* the static part of the delay line 30 of the first apparatus 10 may comprise the same ratio *R_{low}* of unit delay elements 32 having a low threshold voltage, whereas the unit delay elements 32 of the dynamically controllable part have a high threshold voltage. Further, if a minimum ratio of cells having a high threshold voltage in any logic path of the integrated circuit is *R_{high}*, the static part of the delay line 30 of the second apparatus 10 may comprise the same ratio *R_{high}* of unit delay elements 32 having a high threshold voltage, whereas the unit delay elements 32 of the dynamically controllable part have a low threshold voltage. These first and second apparatuses 10 may thus each monitor a speed of the integrated circuit related to a mix of unit delay elements 32 having different threshold voltages. Together, the first and second apparatuses 10 may provide a good tracking of the speed of the integrated circuit over a range of supply voltages. Again, it should be realized that further apparatuses 10 may be used for monitoring speed of integrated circuits having cells of an arbitrary number of different threshold voltages.

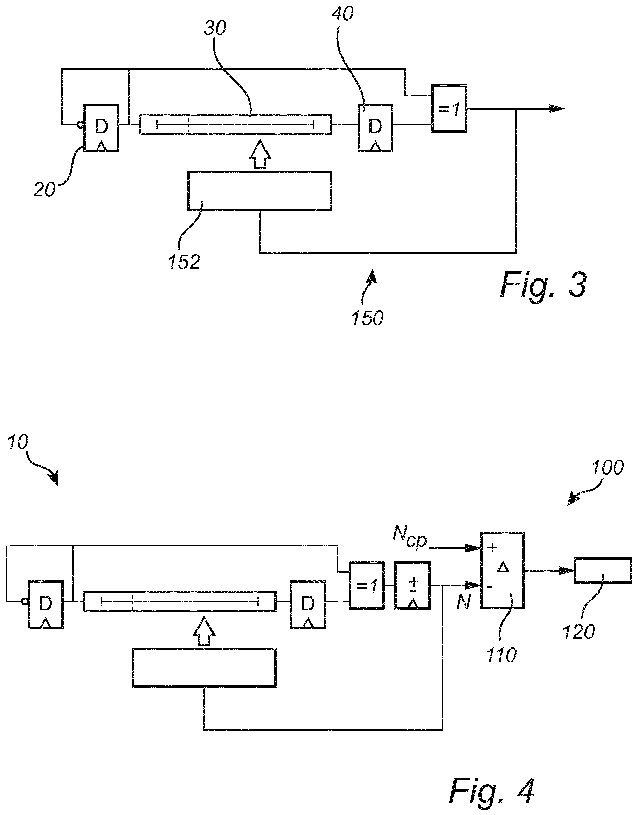

Referring now to Fig. 3, an alternative embodiment of the feedback loop 150 is illustrated. The feedback loop 150 may comprise a shift register 152, instead of the encoder. The shift register 152 may provide a set of binary circuits, each corresponding to a length of the delay line 30, e.g. a return position in the delay line 30.

One of the binary circuits of the shift register 152 may thus hold information differing from the other binary circuits, e.g. a "1" when the other binary circuits code a "0". Thus, the shift register 152 may control the length of the delay line 30 by which binary circuit is activated.

When the comparator 40 determines that the propagated pulse signal arrives late or early, the information in the shift register 152 may be correspondingly shifted such that the binary circuit holding the differing information is changed. Thus, in this embodiment, the counter is not necessary.

Referring now to Fig. 4, use of the apparatus 10 in an adaptive voltage scaling system 100 is illustrated. The apparatus 10 may provide an output of a determined speed of the integrated circuit. The determined speed may be provided as a number N explained above.

The adaptive voltage scaling system 100 may comprise a comparator 110, which compares the determined speed *N* to a threshold speed *N_{cp}* which corresponds to a length of a critical path in the integrated circuit. This threshold speed *N_{cp}* may be constant for a given design of the integrated circuit.

The comparator 110 may thus compare the determined speed *N* to a threshold speed *N_{cp}* and provide a result of the comparison to a voltage controller 120. Thus, if the determined speed is faster than the threshold speed, the supply voltage may be reduced in order to save power. Likewise, if the determined speed is slower than the threshold speed, the supply voltage may be increased in order to ensure that the integrated circuit operates as desired.

When the supply voltage is changed, the speed may be determined again by the apparatus 10 until a speed is determined that matches the threshold speed.

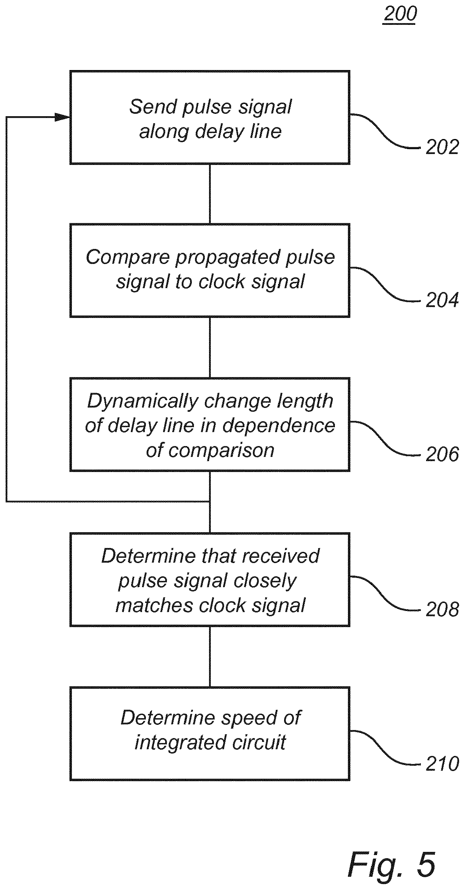

Referring now to Fig. 5, a method 200 for monitoring performance of an integrated circuit will be described.

The method comprises sending a pulse signal, step 202, along a delay line 30, which propagates the pulse signal through a set length of the delay line. The propagated pulse signal is received from the delay line 30 and compared, step 204, to a clock signal. The comparison determines whether the propagated pulse signal is received early or late in relation to the clock signal.

The set length of the delay line 30 is then dynamically changed, step 206, in dependence of the determination whether the propagated pulse signal was received early or late.

The dynamically changed length of the delay line 30 applies to a subsequent pulse signal. Thus, the steps 202-206 are repeated in order to change the length of the delay line 30 to match the clock signal. The change of length of the delay line 30 may be performed in increments of one unit delay element 32 in the delay line 30.

The method further includes a determination that the received pulse signal closely matches the clock signal, step 208. This may for instance be identified by detecting that the length of the delay line 30 is increased and decreased in two subsequent iterations, which may imply that the length of the delay line 30 that would provide a pulse signal exactly matching the clock signal is between the lengths of the delay line 30 used in the two subsequent iterations.

According to an alternative, a determination that the received pulse signal closely matches the clock signal may be made by waiting a sufficiently long predetermined time period to ensure that the feedback loop has settled. A maximum waiting time needed may be determined by the clock frequency and a maximum length of the dynamically controllable part of the delay line 30. If the length of the delay line 30 is adjusted by one increment (or decrement) every clock cycle, the feedback loop will settle within a number of clock cycles corresponding to the maximum length of the dynamically controllable part of the delay line 30. Hence, after the predetermined time period, the length of the delay line 30 will alternate between two values. A simple digital filter may be used to pass the smaller of these values as the length of the delay line 30 that provides a pulse signal closely matching the clock signal.

A speed of the integrated circuit may then be determined, step 210, in relation to the length of the delay line 30 that provided a pulse signal closely matching the clock signal. Thus, the speed of the integrated circuit may be output as a number *N*. As described above, the determined speed may be compared to a threshold speed, and a supply voltage of the integrated circuit may be controlled in dependence of the comparison.

In the above the invention has mainly been described with reference to a limited number of embodiments. However, as is readily appreciated by a person skilled in the art, other embodiments than the ones disclosed above are equally possible within the scope of the invention, as defined by the appended claims.

## Claims

1. An apparatus for monitoring performance of an integrated circuit, said apparatus (10) comprising:
a delay line (30), which is arranged to receive a pulse signal, wherein the delay line (30) has a controllable, variable length and is arranged to propagate the pulse signal through a set length;
a comparator (40), which is arranged to receive the propagated pulse signal from the delay line (30) and a clock signal, said comparator (40) being arranged to determine whether the received signal is received early or late; and
a feedback loop (50; 150), which receives input from the comparator (40) for dynamically increasing or decreasing the set length of the delay line (30) in dependence of the determination by the comparator (40);
wherein said apparatus (10) is arranged to determine a speed of the integrated circuit based on a determination by the comparator (40) that the signal from the delay line (30) closely matches the clock signal.

2. The apparatus according to claim 1, wherein the comparator (40) comprises a single bit indicator (42), which is arranged to switch state on arrival of the propagated pulse signal, said comparator (40) comparing the state of the single bit indicator (42) to the clock signal.

3. The apparatus according to any one of claims 1 or 2, wherein the feedback loop (50; 150) further comprises a length indicator (54; 152), which is arranged to set a length of the delay line (30).

4. The apparatus according to claim 3, wherein the length indicator (54; 152) is arranged to set a return position of the pulse signal in the delay line (30).

5. The apparatus according to claim 3 or 4, wherein the length indicator comprises an encoder (54), which is arranged to output a binary representation of a length of the delay line (30).

6. The apparatus according to claim 5, wherein the feedback loop (50) further comprises a counter (52) for providing input to the encoder (54) for increasing or decreasing the length of the delay line (30).

7. The apparatus according to claim 3 or 4, wherein the length indicator comprises a shift register (152), which comprises a set of binary circuits, wherein each binary circuit corresponds to a length of the delay line (30).

8. The apparatus according to any one of the preceding claims, wherein the delay line (30), the comparator (40) and the feedback loop (50; 150) together form a performance monitor circuit, and wherein the apparatus (10) comprises a first and a second performance monitor circuit and wherein a threshold voltage of the delay line (30) of the first performance monitor circuit is different from a threshold voltage of the delay line (30) of the second performance monitor circuit.

9. The apparatus according to any one of the preceding claims, wherein the delay line (30) comprises a static part and a dynamically configurable part.

10. The apparatus according to any one of the preceding claims, wherein the delay line (30) comprises a chain of multiplexers, wherein a length of the chain through which the pulse signal is propagated is controllable.

11. A device for adaptive voltage scaling for an integrated circuit, said device (100) comprising an apparatus (10) according to any one of the preceding claims, wherein said determined speed of the integrated circuit is input to a voltage controller (120) for controlling a supply voltage of the integrated circuit.

12. A method for monitoring performance of an integrated circuit, said method (200) comprising:
sending (202) a pulse signal along a delay line (30) having a controllable, variable length and being arranged to propagate the pulse signal through a set length;
comparing (204) a received pulse signal from the delay line (30) to a clock signal to determine whether the received signal is received early or late;
in dependence of the determination whether the received signal is received early or late, dynamically changing (206) the set length of the delay line (30);
sending another pulse signal along the delay line (30) using the changed set length; and
repeating the comparing of the received pulse signal from the delay line to a clock signal, dynamically changing the set length of the delay line (30) and sending another pulse signal until the comparing determines (208) that the received pulse signal closely matches the clock signal; and
determining (210) a speed of the integrated circuit based on the determination that the received pulse signal closely matches the clock signal.

13. The method according to claim 12, wherein the delay line (30) comprises a number of unit delay elements (32), and a length of the delay line (30) is controlled by indicating the number of unit delay elements (32) through which the pulse signal is to be propagated.

14. The method according to claim 13, wherein said changing of the set length of the delay line (30) changes the length of the delay line (30) by increasing or decreasing by one the number of unit delay elements (32) of the delay line (30) through which the pulse signal is to be propagated.

15. The method according to any one of claims 12-14, further comprising comparing the determined speed of the integrated circuit to a threshold speed and controlling a supply voltage of the integrated circuit in dependence of the comparison.

## Patentansprüche

1. Vorrichtung zur Überwachung der Leistung einer integrierten Schaltung, wobei die Vorrichtung (10) aufweist:
eine Verzögerungsleitung (30), die dazu eingerichtet ist, ein Pulssignal aufzunehmen, wobei die Verzögerungsleitung (30) eine steuerbare, variable Länge hat und dafür ausgelegt ist das Pulssignal über eine eingestellte Länge auszubreiten;
einen Komparator (40), der dafür ausgelegt ist, das verbreitete Pulssignal von der Verzögerungsleitung (30) und ein Taktgebersignal aufzunehmen, wobei der Komparator (40) dafür ausgelegt ist, zu ermitteln, ob das aufgenommene Signal früh oder spät aufgenommen wurde; und
eine Regelschleife (50; 150), die eine Eingabe von dem Komparator (40) aufnimmt, um die eingestellte Länge der Verzögerungsleitung (30) in Abhängigkeit von der Ermittlung durch den Komparator (40) dynamisch zu erhöhen oder zu verringern;
wobei die Vorrichtung (10) dazu eingerichtet ist, eine Geschwindigkeit der integrierten Schaltung auf der Grundlage einer Ermittlung durch den Komparator (40), dass das Signal von der Verzögerungsleitung (30) mit dem Taktgebersignal eng übereinstimmt, zu ermitteln.

2. Vorrichtung nach Anspruch 1, wobei der Komparator (40) einen Einzelbitindikator (42) aufweist, der dazu eingerichtet ist, seinen Zustand bei Ankunft des verbreiteten Pulssignals umzuschalten, wobei der Komparator (40) den Zustand des Einzelbitindikators (42) mit dem Taktgebersignal vergleicht.

3. Vorrichtung nach einem beliebigen der Ansprüche 1 oder 2, wobei die Regelschleife (50; 150) ferner einen Längenindikator (54; 152) aufweist, der dazu eingerichtet ist, eine Länge der Verzögerungsleitung (30) einzustellen.

4. Vorrichtung nach Anspruch 3, wobei der Längenindikator (54; 152) dafür ausgelegt ist, eine Rückkehrstellung des Pulssignals in der Verzögerungsleitung (30) einzustellen.

5. Vorrichtung nach Anspruch 3 oder 4, wobei der Längenindikator einen Codierer (54) aufweist, der dafür ausgelegt ist, eine binäre Darstellung einer Lange der Verzögerungsleitung (30) auszugeben.

6. Vorrichtung nach Anspruch 5, wobei die Regelschleife (50) ferner einen Zähler (52) aufweist, der dazu dient, eine Eingabe für den Codierer (54) zu erzeugen, um die Länge der Verzögerungsleitung (30) zu erhöhen der zu verringern.

7. Vorrichtung nach Anspruch 3 oder 4, wobei der Längenindikator ein Schieberegister (152) aufweist, das einen Satz von binären Schaltungen aufweist, wobei jede binäre Schaltung einer Länge der Verzögerungsleitung (30) entspricht.

8. Vorrichtung nach einem der vorhergehenden Ansprüche, wobei die Verzögerungsleitung (30), der Komparator (40) und die Regelschleife (50; 150) gemeinsam eine Leistungsüberwachungsschaltung bilden, und wobei die Vorrichtung (10) eine erste und eine zweite Leistungsüberwachungsschaltung aufweist, und wobei sich eine Schwellwertspannung der Verzögerungsleitung (30) der ersten Leistungsüberwachungsschaltung von einer Schwellwertspannung der Verzögerungsleitung (30) der zweiten Leistungsüberwachungsschaltung unterscheidet.

9. Vorrichtung nach einem der vorhergehenden Ansprüche, wobei die Verzögerungsleitung (30) einen statischen Abschnitt und einen dynamisch konfigurierbaren Abschnitt aufweist.

10. Vorrichtung nach einem der vorhergehenden Ansprüche, wobei die Verzögerungsleitung (30) eine Kette von Multiplexern aufweist, wobei eine Länge der Kette, über die das Pulssignal verbreitet wird, steuerbar ist.

11. Bauelement zur adaptiven Spannungsskalierung für eine integrierte Schaltung, wobei das Bauelement (100) eine Vorrichtung (10) nach einem der vorhergehenden Ansprüche aufweist, wobei die ermittelte Geschwindigkeit der integrierten Schaltung in eine Spannungssteuereinrichtung (120) eingegeben wird, um eine Versorgungsspannung der integrierten Schaltung zu steuern.

12. Verfahren zur Überwachung einer integrierten Schaltung, wobei das Verfahren (200) umfasst:
Senden (202) eines Pulssignals entlang einer Verzögerungsleitung (30), die eine steuerbare, variable Länge aufweist, und wobei das Pulssignal dafür ausgelegt ist, über eine eingestellte Länge verbreitet zu werden;
Vergleichen (204) eines aufgenommenen Pulssignals von der Verzögerungsleitung (30) mit einem Taktgebersignal, um zu ermitteln, ob das aufgenommene Signal früh oder spät aufgenommen wurde;
dynamisches Verändern (206) der eingestellten Länge der Verzögerungsleitung (30) in Abhängigkeit von der Ermittlung, ob das aufgenommene Signal früh oder spät aufgenommen wurde;
Senden eines weiteren Pulssignals auf der Verzögerungsleitung (30) unter Verwendung der veränderten eingestellten Länge; und
Wiederholen des Vergleichens des aufgenommenen Pulssignals von der Verzögerungsleitung mit einem Taktgebersignal, dynamisches Verändern der eingestellten Länge der Verzögerungsleitung (30) und Senden eines weiteren Pulssignals, bis das Vergleichen ermittelt (208), dass das aufgenommene Pulssignal mit dem Taktgebersignal eng übereinstimmt; und
Ermitteln (210) einer Geschwindigkeit der integrierten Schaltung auf der Grundlage der Ermittlung, dass das aufgenommene Pulssignal mit dem Taktgebersignal eng übereinstimmt.

13. Verfahren nach Anspruch 12, wobei die Verzögerungsleitung (30) eine Anzahl von Einheitsverzögerungselementen (32) aufweist, und wobei eine Länge der Verzögerungsleitung (30) durch ein Anzeigen der Anzahl von Einheitsverzögerungselementen (32), durch die hindurch das Pulssignal zu verbreiten ist, gesteuert wird.

14. Verfahren nach Anspruch 13, wobei das Verändern der eingestellten Länge der Verzögerungsleitung (30) die Länge der Verzögerungsleitung (30) ändert, indem die Anzahl von Einheitsverzögerungselementen (32) der Verzögerungsleitung (30), durch die hindurch das Pulssignal zu verbreiten ist, um Eins erhöht oder verringert wird.

15. Verfahren nach einem beliebigen der Ansprüche 12-14, ferner mit einem Schritt des Vergleichens der ermittelten Geschwindigkeit der integrierten Schaltung mit einer Schwellwertgeschwindigkeit.

## Revendications

1. Appareil de surveillance des performances d'un circuit intégré, ledit appareil (10) comprenant :
une ligne à retard (30), qui est agencée pour recevoir un signal d'impulsion, dans lequel la ligne à retard (30) présente une longueur variable contrôlable et est agencée pour propager le signal d'impulsion via une longueur établie ;
un comparateur (40), qui est agencé pour recevoir le signal d'impulsion propagé provenant de la ligne à retard (30) et un signal d'horloge, ledit comparateur (40) étant agencé pour déterminer si le signal reçu est reçu plus tôt ou plus tard ; et
une boucle de rétroaction (50 ; 150), qui reçoit une entrée du comparateur (40) pour augmenter ou diminuer dynamiquement la longueur établie de la ligne à retard (30) en fonction de la détermination effectuée par le comparateur (40) ;
dans lequel ledit appareil (10) est agencé pour déterminer une vitesse du circuit intégré sur base d'une détermination par le comparateur (40) du fait que le signal provenant de la ligne à retard (30) s'approche étroitement du signal d'horloge.

2. Appareil selon la revendication 1, dans lequel le comparateur (40) comprend un indicateur monobit (42), qui est agencé pour commuter d'état à l'arrivée du signal d'impulsion propagé, ledit comparateur (40) comparant l'état de l'indicateur monobit (42) au signal d'horloge.

3. Appareil selon l'une quelconque des revendications 1 et 2, dans lequel la boucle de rétroaction (50 ; 150) comprend en outre un indicateur de longueur (54 ; 152), qui est agencé pour établir la longueur de la ligne à retard (30).

4. Appareil selon la revendication 3, dans lequel l'indicateur de longueur (54 ; 152) est agencé pour établir une position de retour du signal d'impulsion dans la ligne à retard (30).

5. Appareil selon la revendication 3 ou 4, dans lequel l'indicateur de longueur comprend un encodeur (54), qui est agencé pour sortir une représentation binaire de la longueur de la ligne à retard (30).

6. Appareil selon la revendication 5, dans lequel la boucle de rétroaction (50) comprend en outre un compteur (52) pour fournir une entrée à l'encodeur (54) afin d'augmenter ou de diminuer la longueur de la ligne à retard (30).

7. Appareil selon la revendication 3 ou 4, dans lequel l'indicateur de longueur comprend un registre à décalage (152), qui comprend un ensemble de circuits binaires, dans lequel chaque circuit binaire correspond à une longueur de la ligne à retard (30).

8. Appareil selon l'une quelconque des revendications précédentes, dans lequel la ligne à retard (30), le comparateur (40) et la boucle de rétroaction (50 ; 150) constituent ensemble un circuit de surveillance des performances, et dans lequel l'appareil (10) comprend un premier circuit de surveillance des performances et un deuxième circuit de surveillance des performances et dans lequel une tension seuil de la ligne à retard (30) du premier circuit de surveillance des performances est différente d'une tension seuil de la ligne à retard (30) du deuxième circuit de surveillance des performances.

9. Appareil selon l'une quelconque des revendications précédentes, dans lequel la ligne à retard (30) comprend une partie statique et une partie configurable dynamiquement.

10. Appareil selon l'une quelconque des revendications précédentes, dans lequel la ligne à retard (30) comprend une chaîne de multiplexeurs, dans lequel la longueur de la chaîne via laquelle le signal d'impulsion est propagé est contrôlable.

11. Dispositif d'ajustement adaptatif de la tension pour un circuit intégré, ledit dispositif (100) comprenant un appareil (10) selon l'une quelconque des revendications précédentes, dans lequel ladite vitesse déterminée du circuit intégré est entrée dans un contrôleur de tension (120) pour contrôler une tension d'alimentation du circuit intégré.

12. Procédé de surveillance des performances d'un circuit intégré, ledit procédé (200) comprenant :
l'envoi (202) d'un signal d'impulsion sur une ligne à retard (30) ayant une longueur variable contrôlable et agencée pour propager le signal d'impulsion via une longueur établie ;
la comparaison (204) d'un signal d'impulsion reçu de la ligne à retard (30) à un signal d'horloge pour déterminer si le signal reçu est reçu plus tôt ou plus tard ;
en fonction de la détermination du fait que le signal reçu est reçu plus tôt ou plus tard, le changement dynamique (206) de la longueur établie de la ligne à retard (30) ;
l'envoi d'un autre signal d'impulsion sur la ligne à retard (30) en utilisant la longueur établie changée ; et
la répétition de la comparaison du signal d'impulsion reçu de la ligne à retard à un signal d'horloge, le changement dynamique de la longueur établie de la ligne à retard (30) et l'envoi d'un autre signal d'impulsion jusqu'à ce que la comparaison détermine (208) que le signal d'impulsion reçu correspond étroitement au signal d'horloge ; et
la détermination (210) d'une vitesse du circuit intégré sur base de la détermination du fait que le signal d'impulsion reçu correspond étroitement au signal d'horloge.

13. Procédé selon la revendication 12, dans lequel la ligne à retard (30) comprend un certain nombre d'éléments à retard unitaires (32), et une longueur de la ligne à retard (30) est contrôlée en indiquant le nombre d'éléments à retard unitaires (32) via lesquels le signal d'impulsion doit être propagé.

14. Procédé selon la revendication 13, dans lequel ledit changement de la longueur établie de la ligne à retard (30) change la longueur de la ligne à retard (30) en augmentant ou en diminuant de un le nombre d'éléments à retard unitaires (32) de la ligne à retard (30) via lesquels le signal d'impulsion doit être propagé.

15. Procédé selon l'une quelconque des revendications 12 à 14, comprenant en outre la comparaison de la vitesse déterminée du circuit intégré à une vitesse seuil et le contrôle d'une tension d'alimentation du circuit intégré en fonction de la comparaison.
